# EUROPEAN PATENT SPECIFICATION

(11) **EP 3 176 286 B1**
(45) Date of publication and mention of the grant of the patent: **24.04.2019**
(21) Application number: 15827384.7
(22) Date of filing: 06.07.2015
(51) Int. Cl.: C23C 28/04, C23C 16/32, C23C 16/02, C23C 16/48

(54) **MULTILAYER COATING MEMBER AND MANUFACTURING METHOD OF MULTILAYER COATING MEMBER**
MEHRSCHICHTIGES BESCHICHTUNGSELEMENT UND VERFAHREN ZUR HERSTELLUNG EINES MEHRSCHICHTIGEN BESCHICHTUNGSELEMENTS
ÉLÉMENT DE REVÊTEMENT MULTICOUCHE ET PROCÉDÉ DE FABRICATION D'UN ÉLÉMENT DE REVÊTEMENT MULTICOUCHE

(30) Priority: 31.07.2014 JP 2014156601
(43) Date of publication of application: 07.06.2017
(73) Proprietor: IBIDEN CO., LTD., Ogaki-shi, Gifu-ken 503-8604 (JP)
(72) Inventor: KUBO Shuichi, Ibi-gun Gifu 501-0695 (JP); KARIYA Satoru, Ibi-gun Gifu 501-0695 (JP); HAN Mingxu, Ibi-gun Gifu 501-0695 (JP); NAKAMURA Tomoyoshi, Ibi-gun Gifu 501-0695 (JP); OHNO Kazushige, Ibi-gun Gifu 501-0695 (JP)
(74) Representative: Winter, Brandl, Fürniss, Hübner, Röss, Kaiser, Polte - Partnerschaft mbB
(86) International application number: PCT/JP2015/069444
(87) International publication number: WO 2016/017378

(56) References cited:
- EP-A1- 2 821 525
- JP-A- H03 257 176
- JP-A- 2001 261 318
- JP-A- 2005 042 185
- JP-A- 2005 042 186
- JP-A- 2006 076 275
- JP-A- 2006 117 975
- US-A1- 2008 138 631
- US-A1- 2009 202 790
- US-A1- 2013 264 723

## Description

### TECHNICAL FIELD

The present invention relates to a multilayer coated member and a method of producing a multilayer coated member.

### BACKGROUND ART

High-temperature devices typified by engine parts or gas turbines of automobiles are required to have heat resistance to withstand high temperature, as well as to have such properties as abrasion resistance or corrosion resistance depending on the use.

In order to provide heat resistance to, for example, metal members, various members including a heat-resistant film formed on a metal substrate have been developed.

Typical heat-resistant films include silicon carbide films. For example, JP H2-504169 T discloses a method of forming a silicon carbide film with a thickness of about 0.1 to 1 µm on a substrate containing magnesium, magnesium alloy, or the like by a method such as a PVD method.

JP 2012-522887 T discloses a member coated with a single SiC layer or an SiC multilayer structure, wherein the SiC layer contains a halogen-containing nanocrystal and is formed by a method such as a thermal CVD method.

JP H9-272987 A discloses a heat-resistant member including a metal substrate, a metal bonding layer containing M-Cr-Al-Y alloy or the like formed on the metal substrate, and a ceramic heat-shielding layer coating the substrate via the metal binding layer.

EP 2 821 525 A1, which is prior art under Article 54(3) EPC, discloses multilayered coatings for compressor blades of turbines which include an adhesion base layer comprising diamond-like carbon (DLC) and adhering to the underlying metal substrate and a top surface layer comprising silicon carbide.

JP H03 257176 A discloses a sintered body with improved wear resistance and peeling resistance wherein a base material such as a metal is coated with a DLC-containing intermediate layer and a boron nitride layer formed on the intermediate layer.

US 2009/0202790 A1 discloses an article with a decorative top layer, wherein the article has a support material such as a metal, a bond layer system comprising a WC layer formed on the substrate, and a DLC-containing layer formed on the bond layer system.

US 2008/0128631 A1 discloses a protective coating for components of an immersion lithography tool, wherein a base material such as a metal may be coated with one or more layers of, for example, silicon carbide or DLC. The layers of material comprising the protective coating may be deposited by chemical vapor deposition (CVD) such as laser-enhanced CVD.

### SUMMARY OF INVENTION

### - Technical problem

In the members disclosed in Patent Literatures 1 and 2, where the silicon carbide layer is directly formed on the metal surface, it is difficult to ensure sufficient adhesion of the silicon carbide film because metal and the silicon carbide layer are less likely to form chemical bonds therebetween. Moreover, due to the large difference in coefficient of thermal expansion between metal and silicon carbide, the silicon carbide film easily peels from the substrate or breaks when the member is subjected to thermal stress or mechanical stress.

Additionally, in the case of forming a film by a CVD method, it is difficult to form a thick film. The resulting member thus fails to exhibit sufficient heat resistance, abrasion resistance, or corrosion resistance. In the case of forming a film by a thermal CVD method, the temperature in film formation is excessively high, so that the metal as the substrate is susceptible to damages in film formation.

The member disclosed in JP H9-272987 A includes an alloy layer between metal and a ceramic heat-shielding layer, with the alloy layer having a coefficient of thermal expansion intermediate between those of the metal and the ceramic layer. This enables prevention of peeling of the ceramic heat-shielding layer due to the difference in coefficient of thermal expansion. However, since metal and the ceramic heat-shielding layer are less likely to form chemical bonds therebetween, even an alloy does not have very strong adhesion to the ceramic heat-shielding layer. The ceramic heat-shielding layer thus may peel when the member is subjected to thermal stress or mechanical force for a long period of time.

The present invention is made to solve such problems. The present invention aims to provide a multilayer coated member including a substrate containing a metal, an amorphous inorganic material layer on the substrate having excellent adhesiveness to the substrate, and a non-oxide ceramic layer on the amorphous inorganic material layer, the multilayer coated member being less likely to suffer peeling or breaking of the amorphous inorganic material layer and the non-oxide ceramic layer even when subjected to thermal stress or mechanical stress, and excellent in heat resistance, abrasion resistance, and corrosion resistance. The present invention also aims to provide a method of producing the multilayer coated member.

### - Solution to problem

The invention is defined by the subject-matter of independent claims 1 and 9. The dependent claims define preferred embodiments of the present invention. In order to achieve the above aims, the multilayer coated member of the present invention includes a substrate containing a metal, an amorphous inorganic material layer formed on the substrate, and a non-oxide ceramic layer formed on the amorphous inorganic material layer.

In the multilayer coated member of the present invention, an amorphous inorganic material layer is formed on the substrate. The difference in coefficient of thermal expansion between the substrate, the amorphous inorganic material layer, and the non-oxide ceramic layer can be reduced by selecting the composition of the amorphous inorganic material layer having a coefficient of thermal expansion intermediate between those of the substrate and the non-oxide ceramic layer. This enables prevention of peeling and the like of the film due to the difference in coefficient of thermal expansion.

In formation of the amorphous inorganic material layer, the metal of the surface of the substrate is oxidized. The amorphous inorganic material layer and the substrate are thus bonded via this metal oxide, whereby the amorphous inorganic material layer can ensure its adhesiveness to the substrate. Similarly, in formation of the non-oxide ceramic layer, the non-oxide ceramic layer is oxidized to form an oxide in the interface between the non-oxide ceramic layer and the amorphous inorganic material layer. The non-oxide ceramic layer and the amorphous inorganic material layer are bonded via this oxide layer, whereby the non-oxide ceramic layer can ensure its adhesiveness to the substrate. The amorphous inorganic material layer and the non-oxide ceramic layer are therefore less likely to peel or break even the multilayer coated member is subjected to thermal stress or mechanical stress. Additionally, in the formation of the non-oxide ceramic layer, the atoms constituting the non-oxide ceramic layer are dispersed in the amorphous inorganic material layer, forming a layer with a gradient in concentration of the atoms constituting the non-oxide ceramic layer in the interface between the amorphous inorganic material layer and the non-oxide ceramic layer. The non-oxide ceramic layer and the amorphous inorganic material layer are bonded via this gradient layer, whereby the non-oxide layer can ensure its adhesiveness to the substrate.

The multilayer coated member of the present invention has, on a surface thereof, a non-oxide ceramic layer excellent in heat resistance, abrasion resistance, and corrosion resistance. The multilayer coated member of the present invention is thus excellent in heat resistance, abrasion resistance, and corrosion resistance.

In the multilayer coated member of the present invention, the amorphous inorganic material constituting the amorphous inorganic material layer contains a low-melting glass having a softening point of 300°C to 1000°C.

With the amorphous inorganic material containing a low-melting glass having a softening point of 300°C to 1000°C, the amorphous inorganic material layer can be relatively easily formed by forming a layer of a material composition for an amorphous inorganic material layer on a substrate by means such as application and then heating the layer.

If the softening point of the low-melting glass is lower than 300°C, the softening point is too low, so that the layer to serve as the amorphous inorganic material layer easily melts, for example, to flow during heating. This makes it difficult to form a layer with a uniform thickness. If the softening point of the low-melting glass is higher than 1000°C, the heating temperature needs to be significantly high. Such heating may deteriorate the mechanical properties of the substrate.

In the multilayer coated member of the present invention, the amorphous inorganic material layer preferably has a thickness of 1 to 1000 µm.

When the thickness of the amorphous inorganic material layer is 1 to 1000 µm, the amorphous inorganic material layer can maintain the mechanical properties.

If the thickness of the amorphous inorganic material layer is less than 1 µm, the amorphous inorganic material layer is too thin and thus less likely to exert its effects when the multilayer coated member is practically used. This makes peeling and the like of the non-oxide ceramic layer more likely to occur. If the thickness of the amorphous inorganic material layer is more than 1000 µm, the amorphous inorganic material layer is too thick, so that the temperature difference between the non-oxide ceramic layer and the substrate tends to be large under thermal shock. This leads to easy breakage of the amorphous inorganic material layer.

In the multilayer coated member of the present invention, the amorphous inorganic material layer preferably contains particles of a crystalline inorganic material.

The particles of a crystalline inorganic material have excellent heat resistance and also serve to mechanically strengthen the amorphous inorganic material layer, thus enabling prevention of cracks and the like due to degradation of the mechanical strength of the amorphous inorganic material layer. The particles also improve the adhesiveness of the amorphous inorganic material layer to the substrate.

In the multilayer coated member of the present invention, the crystalline inorganic material is preferably an oxide containing at least one of manganese dioxide, manganese oxide, iron oxide, cobalt oxide, copper oxide, chromium oxide, and nickel oxide.

In the multilayer coated member of the present invention, the use of an oxide containing the above materials(s) as particles of a crystalline inorganic material improves the adhesiveness of the amorphous inorganic material layer to the substrate.

In the multilayer coated member of the present invention, the crystalline inorganic material is preferably an oxide containing at least one of zirconia, yttria, calcia, magnesia, ceria, alumina, titania, niobium oxide, and hafnia.

Since the oxide containing the above material(s) serves to mechanically strengthen the amorphous inorganic material layer, the multilayer coated member of the present invention can prevent cracks and the like due to degradation of the mechanical strength of the amorphous inorganic material layer.

In the multilayer coated member of the present invention, the substrate preferably contains stainless steel, heat-resistant steel, aluminum, or aluminum alloy.

In the multilayer coated member of the present invention, the use of any of the above metals as the substrate allows the resulting multilayer coated member to serve as various members having appropriate properties according to the use.

In the multilayer coated member of the present invention, the non-oxide ceramic layer preferably has a thickness of 1 to 1000 µm.

In the multilayer coated member of the present invention, setting the thickness of the non-oxide ceramic layer to 1 to 1000 µm allows the multilayer coated member to be further excellent in heat resistance, abrasion resistance, and corrosion resistance.

If the thickness of the non-oxide ceramic layer is less than 1 µm, the non-oxide ceramic layer is too thin and thus less likely to exert its effects such as heat resistance or abrasion resistance. Even if the thickness of the non-oxide ceramic layer is more than 1000 µm, there will be no great change in the properties. Formation of a non-oxide ceramic layer with such a thickness is difficult and time-consuming, resulting in an excessively high price of the multilayer coated member.

In the multilayer coated member of the present invention, the non-oxide ceramic layer preferably contains silicon carbide.

Silicon carbide is excellent in heat resistance, abrasion resistance, and corrosion resistance and thus allows the multilayer coated member of the present invention to be excellent in heat resistance, abrasion resistance, and corrosion resistance.

The method of producing a multilayer coated member of the present invention includes:
a substrate providing step of providing a substrate containing a metal;
a material composition preparing step of preparing a material composition for an amorphous inorganic material layer containing an amorphous inorganic material;
a material composition applying step of applying the material composition for an amorphous inorganic material layer containing an amorphous inorganic material to the substrate and drying the material composition to form a layer of the material composition for an amorphous inorganic material layer on the substrate;
a firing step of heating the substrate on which the layer of the material composition for an amorphous inorganic material layer is formed at 400°C to 1100°C for 3 to 120 minutes to form an amorphous inorganic material layer; and
a non-oxide ceramic layer forming step of forming a non-oxide ceramic layer on the amorphous inorganic material layer by a laser CVD method.

According to the method of producing a multilayer coated member of the present invention, the non-oxide ceramic layer is formed by a laser CVD method in which energy can be supplied at low temperatures, on the amorphous inorganic material layer formed on the substrate under the above conditions. The non-oxide ceramic layer thus can be formed without melting the amorphous inorganic material layer, and the formed non-oxide ceramic layer is excellent in heat resistance, abrasion resistance, and corrosion resistance. This allows the production of a multilayer coated member excellent in heat resistance, abrasion resistance, and corrosion resistance. Additionally, favorable adhesiveness can be obtained between the layers, so that the amorphous inorganic material layer and the non-oxide ceramic layer are less likely to peel or break even when the multilayer coated member is subjected to thermal stress or mechanical stress.

In the method of producing a multilayer coated member of the present invention, in the substrate providing step, the substrate is preferably roughened.

Roughening of the substrate can increase the surface area of the substrate, which leads to improved adhesiveness between the substrate and the amorphous inorganic material layer.

In the method of producing a multilayer coated member of the present invention, in the non-oxide ceramic layer forming step, the amorphous inorganic material layer in formation of the non-oxide ceramic layer preferably has a temperature of 300°C to 1000°C.

In the method of producing a multilayer coated member of the present invention, when the temperature of the amorphous inorganic material layer in formation of the non-oxide ceramic layer is 300°C to 1000°C, the non-oxide ceramic layer can be formed without melting the amorphous inorganic material layer. This allows production of a multilayer coated member with favorable properties.

In view of energy required to form the non-oxide ceramic layer by a laser CVD method, it is technically difficult to set the temperature of the amorphous inorganic material layer to lower than 300°C in formation of the non-oxide ceramic layer. When the temperature of the amorphous inorganic material layer in formation of the non-oxide ceramic layer is higher than 1000°C, the amorphous inorganic material layer easily flows and has a non-uniform thickness or an excessively small thickness.

The "temperature of the amorphous inorganic material layer in formation of the non-oxide ceramic layer" herein means the temperature of a region (reaction region) of the amorphous inorganic material layer where the non-oxide ceramic layer is actually formed by laser CVD.

In the method of producing a multilayer coated member of the present invention, the amorphous inorganic material layer is preferably formed using an amorphous inorganic material containing a low-melting glass having a softening point of 300°C to 1000°C.

In the method of producing a multilayer coated member of the present invention, when the amorphous inorganic material layer is formed using an amorphous inorganic material containing a low-melting glass having a softening point of 300°C to 1000°C, the amorphous inorganic material layer can be relatively easily formed by forming a layer of a material composition for an amorphous inorganic material layer on the substrate by means such as application, and then heating the layer. Additionally, melting of the amorphous inorganic material layer can be prevented in the formation of the non-oxide ceramic layer on the amorphous inorganic material layer by a laser CVD method.

In the method of producing a multilayer coated member of the present invention, the amorphous inorganic material layer formed preferably has a thickness of 1 to 1000 µm.

In the method of producing a multilayer coated member of the present invention, when the thickness of the amorphous inorganic material layer formed is 1 to 1000 µm, the resulting multilayer coated member can maintain the mechanical characteristics.

If the thickness of the amorphous inorganic material layer is less than 1 µm, the amorphous inorganic material layer is too thin, so that peeling and the like of the non-oxide ceramic layer easily occurs when the multilayer coated member is practically used. If the thickness of the amorphous inorganic material layer is more than 1000 µm, the amorphous inorganic material layer is too thick, so that the temperature difference between the non-oxide ceramic layer and the substrate tends to be large under thermal shock, leading to easy breakage of the amorphous inorganic material layer.

In the method of producing a multilayer coated member of the present invention, in the material composition preparing step, preferably the material composition for an amorphous inorganic material layer contains particles of a crystalline inorganic material.

When the material composition for an amorphous inorganic material layer contains particles of a crystalline inorganic material in the material composition preparing step, the formed amorphous inorganic material layer contains the crystalline inorganic material, which mechanically strengthens the amorphous inorganic material layer. This enables prevention of cracks and the like due to degradation of the mechanical strength of the amorphous inorganic material layer. Additionally, the amorphous inorganic material layer can have improved adhesiveness to the substrate.

In the method of producing a multilayer coated member of the present invention, the crystalline inorganic material is preferably an oxide containing at least one of manganese dioxide, manganese oxide, iron oxide, cobalt oxide, copper oxide, chromium oxide, and nickel oxide.

In the method of producing a multilayer coated member of the present invention, the use of an oxide containing the above material(s) as the particles of a crystalline inorganic material improves the adhesiveness of the amorphous inorganic material layer to the substrate.

In the method of producing a multilayer coated member of the present invention, the crystalline inorganic material is preferably an oxide containing at least one of zirconia, yttria, calcia, magnesia, ceria, alumina, titania, niobium oxide, and hafnia.

In the method of producing a multilayer coated member of the present invention, the oxide containing the above material(s) serves to mechanically strengthen the amorphous inorganic material layer, enabling prevention of cracks due to degradation of the mechanical strength of the amorphous inorganic material layer.

In the method of producing a multilayer coated member of the present invention, the substrate preferably contains stainless steel, heat-resistant steel, aluminum, or aluminum alloy.

In the method of producing a multilayer coated member of the present invention, the use of any of the above metals as the substrate allows the resulting multilayer coated member to serve as various members having appropriate properties according to the use.

In the method of producing a multilayer coated member of the present invention, the non-oxide ceramic layer formed preferably has a thickness of 1 to 1000 µm.

In the method of producing a multilayer coated member of the present invention, setting the thickness of the non-oxide ceramic layer to 1 to 1000 µm allows the multilayer coated member to be further excellent in heat resistance, abrasion resistance, and corrosion resistance.

If the thickness of the non-oxide ceramic layer is less than 1 µm, the non-oxide ceramic layer is too thin and thus less likely to exert its effects such as heat resistance or abrasion resistance. Even if the thickness of the non-oxide ceramic layer is more than 1000 µm, there will be no great change in the properties. Formation of a non-oxide ceramic layer with such a thickness is difficult and time-consuming, resulting in an excessively high price of the multilayer coated member.

In the method of producing a multilayer coated member of the present invention, the non-oxide ceramic layer preferably contains silicon carbide.

Silicon carbide is excellent in heat resistance, abrasion resistance, and corrosion resistance, and thus allows the multilayer coated member of the present invention to be excellent in heat resistance, abrasion resistance, and corrosion resistance.

### BRIEF DESCRIPTION OF DRAWINGS

Fig. 1 is a schematic cross-sectional view of an example of the multilayer coated member of the present invention.
Fig. 2 is a cross-sectional view of an embodiment of the multilayer coated member of the present invention in which the amorphous inorganic material layer contains crystalline inorganic particles.

### DETAILED DESCRIPTION OF THE INVENTION

In the following, embodiments of the present invention will be specifically described. The present invention, however, is not limited to these embodiments.

The multilayer coated member and method of producing a multilayer coated member of the present invention will be described below.

The multilayer coated member of the present invention includes a substrate containing a metal, an amorphous inorganic material layer formed on the substrate, and a non-oxide ceramic layer formed on the amorphous inorganic material layer.

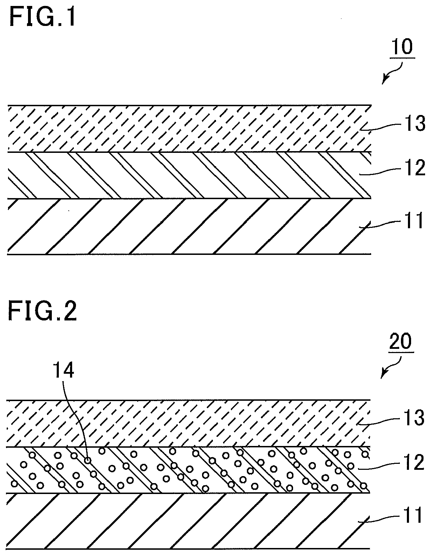

Fig. 1 is a schematic cross-sectional view of an example of the multilayer coated member of the present invention.

A multilayer coated member 10 shown in Fig. 1 includes a substrate 11 containing a metal, an amorphous inorganic material layer 12 formed on the substrate 11, and a non-oxide ceramic layer 13 formed on the amorphous inorganic material layer 12.

Examples of the materials for the substrate 11 constituting the multilayer coated member 10 of the present invention include stainless steel, heat-resistant steel, aluminum, aluminum alloy, iron, Inconel, Hastelloy, and invar. Other examples of the materials for the substrate 11 include castings (e.g., cast iron, cast steel, carbon steel).

As described later, bringing the coefficient of thermal expansion of the substrate 11 containing such a metal material close to that of the amorphous inorganic material layer 12 can improve adhesiveness between the amorphous inorganic layer 12 and the substrate 11 containing a metal.

In order to achieve favorable adhesiveness between the substrate 11 and the amorphous inorganic material layer 12, the surface of the substrate may be subjected to roughening, such as sandblasting or roughening using chemicals.

The surface of the substrate formed by the roughening is preferably has a surface roughness Rz_{JIS} of 0.3 to 20 µm. The surface roughness Rz_{JIS} of the roughened surface is the ten-point average roughness defined in JIS B 0601 (2001).

If the surface roughness Rz_{JIS} of the roughened surface of the substrate is less than 0.3 µm, the substrate has a small surface area, which makes it difficult to achieve sufficient adhesiveness between the substrate and the amorphous inorganic material layer. If the surface roughness Rz_{JIS} of the roughened surface of the substrate is more than 20 µm, it is difficult to form a proper amorphous inorganic material layer on the substrate. This is presumably because if the surface roughness Rz_{JIS} of the roughened surface of the substrate is too large, slurry (material composition for an amorphous inorganic material layer) fails to enter the recess portions among the recesses and protrusions formed on the substrate surface, thus causing voids in such portions.

The surface roughness Rz_{JIS} of the roughened surface of the substrate of the multilayer coated member can be measured using HANDYSURF E-35B available from Tokyo Seimitsu Co., Ltd. in accordance with JIS B 0601 (2001).

The substrate may have a plate shape, a semicylindrical shape, a cylindrical shape, or any other shape, and the cross section may have any peripheral shape, such as an elliptic or polygonal shape. Alternatively, the substrate may have the shape of a predetermined member such as an engine member.

When the substrate of the multilayer coated member has a tubular shape, the diameter of the substrate may not be constant along the longitudinal direction, and the cross-sectional shape perpendicular to the longitudinal direction may not be constant along the longitudinal direction.

In the multilayer coated member of the present invention, the lower limit of the thickness of the substrate is preferably 0.2 mm, more preferably 0.4 mm. The upper limit thereof is preferably 10 mm, more preferably 4 mm.

If the thickness of the substrate of the multilayer coated member is less than 0.2 mm, the multilayer coated member has insufficient strength. If the thickness of the substrate of the multilayer coated member is more than 10 mm, the multilayer coated member has a large weight and thus is less suitable for practical use.

In the multilayer coated member 10 of the present invention, the amorphous inorganic material layer 12 is formed on the substrate 11.

The amorphous inorganic material constituting the amorphous inorganic material layer 12 of the multilayer coated member of the present invention contains a low-melting glass having a softening point of 300°C to 1000°C.

Any low-melting glass may be used. Examples thereof include soda-lime glass, alkali-free glass, borosilicate glass, potash glass, crystal glass, titanium crystal glass, barium glass, strontium glass, alumino-silicate glass, soda zinc glass, and soda barium glass.

These glasses may be used alone or in combination of two or more thereof.

With such a low-melting glass having a softening point in the range of 300°C to 1000°C, the amorphous inorganic material layer 12 can be easily formed on the surface of the substrate containing a metal by applying (coating) powder (particles) of the low-melting glass onto the surface of the substrate (metal material) followed by heating and firing. Additionally, the amorphous inorganic material layer thus formed can have excellent adhesiveness to the substrate.

If the softening point of the low-melting glass is lower than 300°C, the softening point is too low, so that the layer to serve as the amorphous inorganic material layer easily melts, for example, to flow during heating. This makes it difficult to form a layer with a uniform thickness. If the softening point of the low-melting glass is higher than 1000°C, heating temperature needs to be set significantly high. Such heating may deteriorate the mechanical properties of the substrate.

The softening point can be measured in accordance with JIS R 3103-1:2001 using, for example, an automatic glass softening point/strain point measurement apparatus (SSPM-31), available from Opt Corporation.

The borosilicate glass is not limited. Examples thereof include SiO₂-B₂O₃-ZnO glass and SiO₂-B₂O₃-Bi₂O₃ glass. The crystal glass, which is a glass containing PbO, is not limited. Examples thereof include SiO₂-PbO glass, SiO₂-PbO-B₂O₃ glass, and SiO₂-B₂O₃-PbO glass. The barium glass is not limited. Examples thereof include BaO-SiO₂ glass.

The amorphous inorganic material may contain only one of the above-mentioned low-melting glasses, or may contain two or more of the low-melting glasses.

The amorphous inorganic material layer constituting the multilayer coated member of the present invention may contain particles of a crystalline inorganic material.

Fig. 2 is a cross-sectional view of an example of the multilayer coated member of the present invention in which the amorphous inorganic material layer contains crystalline inorganic particles.

A multilayer coated member 20 shown in Fig. 2 includes a substrate 11 containing a metal, an amorphous inorganic material layer 12 formed on the substrate 11, and a non-oxide ceramic layer 13 formed on the amorphous inorganic material layer 12. The amorphous inorganic material layer 12 contains crystalline inorganic material particles 14.

The crystalline inorganic material particles 14 contained in the amorphous inorganic material layer preferably have a higher softening point than the amorphous inorganic material contained in the amorphous inorganic material layer of the multilayer coated member. Specifically, the crystalline inorganic material contained in the amorphous inorganic material layer of the multilayer coated member preferably has a softening point of 950°C or higher.

The crystalline inorganic material constituting the crystalline inorganic material particles 14 dispersed in the amorphous inorganic material layer may be particles of an oxide containing at least one of manganese dioxide, manganese oxide, iron oxide, cobalt oxide, copper oxide, chromium oxide, and nickel oxide, or may be particles of an oxide containing at least one of zirconia, yttria, calcia, magnesia, ceria, alumina, titania, niobium oxide, and hafnia.

When the crystalline inorganic material constituting the crystalline inorganic material particles 14 is an oxide containing at least one of manganese dioxide, manganese oxide, iron oxide, cobalt oxide, copper oxide, chromium oxide, and nickel oxide, the amorphous inorganic material layer can have improved adhesiveness to the substrate.

When the crystalline inorganic material constituting the crystalline inorganic material particles 14 is an oxide containing at least one of zirconia, yttria, calcia, magnesia, ceria, alumina, titania, niobium oxide, and hafnia, the oxide serves to mechanically strengthen the amorphous inorganic material layer, enabling prevention of cracks and the like due to degradation of the mechanical strength of the amorphous inorganic material layer.

Alternatively, the crystalline inorganic material particles 14 may be particles of a crystalline inorganic material containing zirconia.

Specific examples of the inorganic material containing zirconia include CaO stabilized zirconia (5 wt% CaO-ZrO₂, 8 wt% CaO-ZrO₂, 31 wt% CaO-ZrO₂), MgO stabilized zirconia (20 wt% MgO-ZrO₂, 24 wt% MgO-ZrO₂), Y₂O₃ stabilized zirconia (6 wt% Y₂O₃-ZrO₂, 7 wt% Y₂O₃-ZrO₂, 8 wt% Y₂O₃-ZrO₂, 10 wt% Y₂O₃-ZrO₂, 12 wt% Y₂O₃-ZrO₂, 20 wt% Y₂O₃-ZrO₂), zircon (ZrO₂-33 wt% SiO₂), and CeO stabilized zirconia.

Preferred among these materials are Y₂O₃ stabilized zirconia, CaO stabilized zirconia, and MgO stabilized zirconia, which are excellent in heat resistance and corrosion resistance and have a thermal conductivity at 25°C of 4 W/mK or less. The crystalline inorganic material particles 14 preferably have an average particle diameter of 0.1 to 150 µm.

The amorphous inorganic material layer 12 preferably has a thickness of 1 to 1000 µm, more preferably 5 to 500 µm, still more preferably 5 to 30 µm.

If the thickness of the amorphous inorganic material layer 12 is less than 1 µm, the amorphous inorganic material layer 12 is too thin and thus less likely to exert its effects when the multilayer coated member is practically used. This makes peeling and the like of the non-oxide ceramic layer more likely to occur. If the thickness of the amorphous inorganic material layer 12 is more than 1000 µm, the amorphous inorganic material layer 12 is too thick, so that the temperature difference between the non-oxide ceramic layer and the substrate tends to be large under thermal shock. This leads to easy breakage of the amorphous inorganic material layer 12.

The amount of the crystalline inorganic material contained in the amorphous inorganic material layer 12 is preferably 1 to 50% by weight, more preferably 10 to 45% by weight relative to the total weight of the amorphous inorganic material and the crystalline inorganic material.

Furthermore, in the multilayer coated member 10 of the present invention, the non-oxide ceramic layer 13 is formed on the amorphous inorganic material layer 12.

Examples of the non-oxide ceramic constituting the non-oxide ceramic layer 13 of the multilayer coated member 10 of the present invention include nitride ceramics such as aluminum nitride, silicon nitride, boron nitride, and titanium nitride and carbide ceramics such as silicon carbide, zirconium carbide, titanium carbide, tantalum carbide, and tungsten carbide. Preferred among these ceramics is silicon carbide, which is excellent in heat resistance, abrasion resistance, and corrosion resistance.

The non-oxide ceramic layer 13 preferably has a thickness of 1 to 1000 µm, more preferably 5 to 500 µm.

In the multilayer coated member of the present invention, setting the thickness of the non-oxide ceramic layer to 1 to 1000 µm allows the multilayer coated member to be further excellent in heat resistance, abrasion resistance, and corrosion resistance.

If the thickness of the non-oxide ceramic layer is less than 1 µm, the non-oxide ceramic layer is too thin and thus less likely to exert its effects such as heat resistance and abrasion resistance. Even if the thickness of the non-oxide ceramic layer is more than 1000 µm, there will be no great change in the properties. Formation of a non-oxide ceramic layer with such a thickness is difficult and time-consuming, resulting in an excessively high price of the multilayer coated member.

In the following, the method of producing a multilayer coated member of the present invention will be described.

The method of producing a multilayer coated member of the present invention includes:
a substrate providing step of providing a substrate containing a metal;
a material composition preparing step of preparing a material composition for an amorphous inorganic material layer containing an amorphous inorganic material;
a material composition applying step of applying the material composition for an amorphous inorganic material layer containing an amorphous inorganic material to the substrate and drying the material composition to form a layer of the material composition for an amorphous inorganic material layer on the substrate;
a firing step of heating the substrate on which the layer of the material composition for an amorphous inorganic material layer is formed at 400°C to 1100°C for 3 to 120 minutes to form an amorphous inorganic material layer; and
a non-oxide ceramic layer forming step of forming a non-oxide ceramic layer on the amorphous inorganic material layer by a laser CVD method.

### (1) Substrate providing step

In the present invention, first, a substrate containing a metal is provided (substrate providing step).

A substrate containing a metal (hereinafter also referred to as a metal substrate or metal material) as a starting material is first cleaned to remove impurities on its surface.

The cleaning is not limited. Any conventionally known cleaning may be employed, such as ultrasonic cleaning in an alcohol solvent.

After the cleaning, if necessary, the surface of the metal substrate may be roughened to increase the specific surface area of the surface of the metal substrate or to adjust the roughness of the surface of the metal substrate. Specifically, roughening such as sandblasting, etching, or high-temperature oxidation may be performed. These treatments may be used alone or in combination of two or more thereof.

Additional cleaning may be performed after roughening.

If necessary, degreasing may be performed after the above treatments. Degreasing is a treatment in which the metal substrate is put in a furnace in an air atmosphere at 400°C to 600°C for 5 to 120 minutes to remove organic components.

The material, surface roughness, and the like of the substrate have already been described for the multilayer coated member of the present invention, and thus are not described here.

### (2) Material composition preparing step

Next, in the present invention, a material composition for an amorphous inorganic material layer containing an amorphous inorganic material is prepared (material composition preparing step).

Specifically, particles of an amorphous inorganic material containing a low-melting glass having a softening point of 300°C to 1000°C are blended with a dispersion medium, an organic binder, and other material(s) to prepare a material composition for an amorphous inorganic material layer.

The particles of the amorphous inorganic material can be prepared by wet pulverizing the low-melting glass.

The final average particle diameter of the wet pulverized amorphous inorganic material is preferably 0.1 to 100 µm, more preferably 1 to 20 µm. With the average particle diameter in the range of 1 to 20 µm, the particles are easily dispersed, presumably because the effects of the electrical charge on the particle surface are small.

Examples of the dispersion medium include organic solvents such as water, methanol, ethanol, and acetone. The powder of the amorphous inorganic material and the dispersion medium in the material composition for an amorphous inorganic material layer may be mixed at any ratio. For example, the amount of the dispersion medium is preferably 50 to 150 parts by weight relative to 100 parts by weight of the powder of the amorphous inorganic material. With such a mixing ratio, the material composition can have a viscosity suitable for application to the substrate.

Examples of organic binders that can be mixed in the material composition for an amorphous inorganic material layer include polyvinyl alcohol, methylcellulose, ethylcellulose, and carboxymethylcellulose. These binders may be used alone or in combination of two or more thereof.

The dispersion medium and the organic binder may be used in combination.

The powder of the amorphous inorganic material and the organic binder in the material composition for an amorphous inorganic material layer may be mixed at any ratio. For example, the amount of the organic binder is preferably 0.1 to 15 parts by weight relative to 100 parts by weight of the powder of the amorphous inorganic material.

First, an amorphous inorganic material and if necessary, a dispersion medium, an organic binder, and other material(s) are mixed to prepare a material composition for an amorphous inorganic material layer.

Specifically, powder of an amorphous inorganic material adjusted to have a predetermined particle diameter is blended with, if necessary, a dispersion medium such as water and an organic binder. The materials are wet mixed with a ball mill or the like to prepare a material composition for an amorphous inorganic material layer.

In the case of adding a crystalline inorganic material, powder of a crystalline inorganic material and powder of an amorphous inorganic material are prepared such that they each have predetermined particle diameter and shape and other predetermined properties. The powders are dry mixed at a predetermined ratio to prepare a mixed power, and to this mixed powder are added a dispersion medium such as water and an organic binder. This is followed by wet mixing with a ball mill or the like, whereby a material composition for an amorphous inorganic material layer is prepared.

### (3) Material composition applying step

Subsequently, the material composition for an amorphous inorganic material layer containing an amorphous inorganic material is applied onto the substrate and dried to form a dried layer of the material composition for an amorphous inorganic material layer (material composition applying step).

The material composition for an amorphous inorganic material layer may be coated by, for example, spray coating, electrostatic coating, transferring using an ink-jet printer, a stamp, or a roll, brush coating, or electrocoating.

Alternatively, the metal substrate may be immersed into the material composition for an amorphous inorganic material layer to form a coat layer of the material composition for an amorphous inorganic material layer.

### (4) Firing step

Subsequently, the substrate on which the layer of the material composition for an amorphous inorganic material layer is formed is heated at 400°C to 1100°C for 3 to 120 minutes to form an amorphous inorganic material layer (firing step).

The heating temperature is preferably equal to or higher than the softening point of the amorphous inorganic material, and is preferably 700°C to 1100°C although it depends on the type of the amorphous inorganic material used. With the heating temperature equal to or higher than the softening point of the amorphous inorganic material, the metal substrate and the amorphous inorganic material are firmly bonded to each other, enabling formation of an amorphous inorganic material layer firmly bonded to the metal substrate.

If the heating temperature is lower than 400°C, it is difficult to firmly bond the amorphous inorganic material layer to the substrate. If the heating temperature is higher than 1100°C, the amorphous inorganic material has an excessively low viscosity, so that an amorphous inorganic material layer with a uniform thickness is less likely to be formed.

If the heating time is shorter than 3 minutes, the amorphous inorganic material fails to sufficiently melts, making it difficult to bond the amorphous inorganic material layer to the substrate. Even if the heating time is longer than 120 minutes, the amorphous inorganic material are less likely to have better properties than the amorphous inorganic material heated for a shorter period of time. Rather, the amorphous inorganic material layer melts to easily flow on the surface of the substrate, so that an amorphous inorganic material layer with a uniform thickness is less likely to be formed.

The type, material, material quality, properties, and the like of the amorphous inorganic material have already been described for the multilayer coated member of the present invention, and thus are not described here. The amorphous inorganic material is applied to the surface of the substrate, fired, and then melted to form a coating film (amorphous inorganic material layer). Thus, it is not necessary to strictly control the particle diameter of the amorphous inorganic material. However, in order to form a void-free, dense amorphous inorganic material layer, the particle diameter of the amorphous inorganic material is preferably controlled. In the case of adding particles of a crystalline inorganic material, the crystalline inorganic material particles need to be uniformly dispersed in the material composition for an amorphous inorganic material layer.

### (5) Non-oxide ceramic layer forming step

Subsequently, a non-oxide ceramic layer is formed on the amorphous inorganic material layer by laser CVD (non-oxide ceramic layer forming step).

CVD is short for chemical vapor deposition. In CVD, materials for film formation are fed in gaseous form and chemically reacted in the gas phase to form a film.

In the present invention, laser CVD is employed. The material gas is excited by irradiation with powerful laser light, thereby pyrolysis of the material gas and a non-oxide producing reaction occur to form a non-oxide ceramic layer on the amorphous inorganic material layer. Laser light facilitates the control of the reactions because it has a constant wavelength and uniform energy distribution. Any laser may be used in the present invention. Examples thereof include excimer lasers such as ArF laser (wavelength 193 nm), KrF laser (wavelength 248 nm), and XeF laser (wavelength 351 nm), argon laser (417 nm, 514 nm), He-Ne laser (632.8 nm), CO₂ laser with a far-infrared wavelength, YAG laser (1064 nm) with a near-infrared wavelength, and harmonics of these lasers. For example, with the fifth harmonic of YAG laser, light having a wavelength of 213 nm can be obtained.

Examples of the non-oxide ceramic used for forming the non-oxide ceramic layer include nitrides and oxides such as those mentioned for the multilayer coated member of the present invention. Examples of materials for forming the non-oxide ceramic layer include SiCl₄, SiF₄, SiBr₄, SiI₄, CH₃SiCl₃, C₂H₆SiCl₂, C₃H₉SiCl, SiH₄, TaCl₅, hexamethyldisilazane (HMDS: (CH₃)₃Si-NH-Si(CH₃)₃), hexamethyldisilane (HMDS: (CH₃)₃Si-Si(CH₃)₃), and hexamethyltrisilazane (HMCTS). For formation of a non-oxide ceramic layer containing C, N, or the like, hydrocarbon gas such as methane, ethane, propane, or ethylene, an amine such as methylamine, dimethylamine, or trimethylamine, ammonia, or other such material(s) may be further added.

Laser CVD is preferably performed by placing the substrate on which the amorphous inorganic material layer is formed into an apparatus configured to allow performing laser CVD; feeding the above material(s) for forming a non-oxide ceramic layer alone or a mixed gas of the material(s) and a carrier gas (e.g., rare gas such as argon, hydrogen) to the apparatus such that the total pressure is 300 to 600 Pa and the partial pressure of the carrier gas is 2 to 100 times that of the material gas; and irradiating the material(s) with, for example, a semiconductor (AlGaAs) laser light to form a non-oxide ceramic layer on the amorphous inorganic material layer. If the materials can be fed in gaseous form without any particular treatment, they may be fed as is. If the materials are liquid or solid, they need to be gasified by heating or any other treatment.

In film formation by laser CVD, the temperature of the region of the amorphous inorganic material layer other than the reaction region (described below) is preferably 25°C to 1000°C. The temperature of the reaction region of the amorphous inorganic material layer, where the reaction actually proceeds to form a non-oxide ceramic layer, is preferably 300°C to 1000°C and also preferably higher than the temperature of the region other than the reaction region.

A non-oxide ceramic layer with a thickness of 5 to 500 µm can be formed by the reaction by laser CVD for 5 to 180 minutes under the above conditions.

The film thicknesses of the amorphous inorganic material layer and the non-oxide ceramic layer constituting the multilayer coated member of the present invention can be measured from a SEM image or an image obtained with a digital microscope, for example.

In the case of a SEM image, a cross section perpendicular to the surface of the multilayer coated member is photographed at 50 to 10000-fold magnification. The film thickness is measured at randomly selected five points on the obtained SEM image using a scale, and the average of the five points is taken as the film thickness. In the case of a digital microscope, a cross section perpendicular to the surface of the multilayer coated member is photographed with, for example, digital microscope VHX-1000 available from Keyence Corporation. The film thickness is measured at randomly selected five points using a scale, and the average of the five points is taken as the film thickness.

In formation of the non-oxide ceramic layer, the atoms constituting the non-oxide ceramic layer are dispersed in the amorphous inorganic material layer, forming a layer with a gradient in concentration of the atoms constituting the non-oxide ceramic layer in the interface between the amorphous inorganic material layer and the non-oxide ceramic layer. The non-oxide ceramic layer and the amorphous inorganic material layer are bonded via this gradient layer, whereby the non-oxide ceramic layer can ensure its adhesiveness to the substrate.

The type, materials, material quality, properties, and the like of the multilayer coated member of the present invention have already been described above, and therefore are not described here.

The effects of the multilayer coated member and the method of producing a multilayer coated member of the present invention are listed below.
(1) In the multilayer coated member of the present invention, in formation of the amorphous inorganic material layer on the substrate, the metal of the surface of the substrate is oxidized. The amorphous inorganic material layer and the substrate are thus bonded via this metal oxide, whereby the amorphous inorganic material layer can ensure its adhesiveness to the substrate. Similarly, in formation of the non-oxide ceramic layer, the non-oxide ceramic layer is oxidized to form an oxide in the interface between the non-oxide ceramic layer and the amorphous inorganic material layer. The non-oxide ceramic layer and the amorphous inorganic material layer are bonded via this oxide layer, whereby the non-oxide ceramic layer can ensure its adhesiveness to the substrate. The amorphous inorganic material layer and the non-oxide ceramic layer are therefore less likely to peel or break even the multilayer coated member is subjected to thermal stress or mechanical stress. Additionally, in the formation of the non-oxide ceramic layer, the atoms constituting the non-oxide ceramic layer are dispersed in the amorphous inorganic material layer, forming a layer with a gradient in concentration of the atoms constituting the non-oxide ceramic layer in the interface between the amorphous inorganic material layer and the non-oxide ceramic layer. The non-oxide ceramic layer and the amorphous inorganic material layer are bonded via this gradient layer, whereby the non-oxide layer can ensure its adhesiveness to the substrate.
(2) The multilayer coated member of the present invention has, on a surface thereof, a non-oxide ceramic layer excellent in heat resistance, abrasion resistance, and corrosion resistance. The multilayer coated member is thus excellent in heat resistance, abrasion resistance, and corrosion resistance.
(3) In the multilayer coated member of the present invention, in the case that the amorphous inorganic material layer contains particles of a crystalline inorganic material, the particles of a crystalline inorganic material serve to mechanically strengthen the amorphous inorganic material layer, enabling prevention of cracks and the like due to degradation of the mechanical strength of the amorphous inorganic material layer.
   Additionally, the amorphous inorganic material layer can have improved adhesiveness to the substrate.
(4) In the multilayer coated member of the present invention, by means of using a low-melting glass having a softening point of 300°C to 1000°C as the amorphous inorganic material constituting the amorphous inorganic material layer, the amorphous inorganic material layer can be relatively easily formed by forming a layer of a material composition for an amorphous inorganic material layer on the substrate by means such as application and then heating the layer. Additionally, in such a case, the amorphous inorganic material layer is less susceptible to damages even when a non-oxide ceramic layer is formed on the amorphous inorganic material layer by laser CVD.

### EXAMPLES

The following examples more specifically disclose a first embodiment of the present invention. These examples, however, are not intended to limit the scope of the present invention.

### (Example 1)

### (1) Substrate providing step

A plate-shaped stainless steel (SUS430) substrate having a size of 40 mm (length) × 40 mm (width) × 1.5 mm (thickness) as a metal substrate was ultrasonically cleaned in an alcohol solvent, and subsequently sandblasted so that the both surfaces of the substrate were roughened. The sandblasting was performed using Al₂O₃ abrasive grains of #100 for 10 minutes. Then the substrate was put in a furnace in an air atmosphere at 400°C for one minute to be degreased.

The surface roughness of the metal substrate was measured using a surface-roughness measuring device (HANDYSURF E-35B, Tokyo Seimitsu Co., Ltd.). The surface roughness Rz_{JIS} was 8.8 µm.

In this manner, a plate-shaped substrate was prepared.

### (2) Material composition preparing step

K4006A-100M (Bi₂O₃-B₂O₃ glass, softening point: 770°C., Asahi Glass Co., Ltd.) in an amount of 35 parts by weight was provided as powder of an amorphous inorganic material. The proportion of the amorphous inorganic material to the entire material composition for an amorphous inorganic material layer was 34% by weight. This proportion is the proportion of the amorphous inorganic material expressed in percentage to the total weight of the material composition for an amorphous inorganic material layer including water and the like. The powder of an amorphous inorganic material had an average particle diameter of 15 µm and contained 25% by weight of silica.

Further, 0.5 parts by weight of methylcellulose (product name: METOLOSE-65SH) available from Shin-Etsu Chemical Co., Ltd. was provided as an organic binder.

Further, 46 parts by weight of water was added, followed by wet mixing with a ball mill, whereby a material composition for an amorphous inorganic material layer to be used for forming an amorphous inorganic material layer was prepared.

### (3) Material composition applying step and firing step

The material composition for an amorphous inorganic material layer prepared was applied to one surface of the plate-shaped substrate by spray coating and dried in a drying device at 70°C for 20 minutes. This was followed by heating and firing in the air at 850°C for 90 minutes, whereby an amorphous inorganic material layer with a thickness of 25 µm was obtained.

### (4) Non-oxide ceramic layer forming step

The sample in which the amorphous inorganic material layer was formed on the substrate was put in the chamber of a laser CVD film-forming device configured to allow performing laser CVD. Argon (Ar) gas as a carrier gas was fed through a gas flow rate controller, and hexamethyldisilane (HMDS) as a material for forming a silicon carbide film was excited in the heating chamber. The hexamethyldisilane (HMDS) thus excited was delivered to the nozzle with Ar gas.

The hexamethyldisilane (HMDS) fed into the chamber through the nozzle was excited by irradiation with laser light (wavelength: 1064 nm) through the window, so that pyrolysis and a silicon carbide-producing reaction proceeded. The resulting silicon carbide was deposited on the surface of the amorphous inorganic material layer on the substrate placed on the heating stage. Thus, a silicon carbide-containing non-oxide ceramic layer with a thickness of 5 µm was formed.

The heating stage was equipped with a thermocouple with which the temperature in the chamber (i.e., film formation temperature) was monitored. Gas in the chamber was discharged through a vacuum pump.

The film formation was performed under the conditions of a laser output of 500 W, a film formation temperature (temperature of the reaction region of the amorphous inorganic material layer) of 820°C, a film forming rate of 5 µm/Hr, and a carrier gas flow rate of 700 sccm. The unit "sccm", short for standard cc/min, indicates the flow rate standardized to 1 atm (atmospheric pressure: 1013 hPa) and 25°C.

### REFERENCE SIGNS LIST

- 10, 20: multilayer coated member
- 11: substrate
- 12: amorphous inorganic material layer
- 13: non-oxide ceramic layer
- 14: particles of crystalline inorganic material

## Claims

1. A multilayer coated member (10, 20), comprising:
a substrate (11) containing a metal;
an amorphous inorganic material layer (12) formed on the substrate (11); and
a non-oxide ceramic layer (13) formed on the amorphous inorganic material layer (12),
**characterized in that**
the amorphous inorganic material layer (12) contains an amorphous inorganic material which contains a low-melting glass having a softening point of 300°C to 1000°C.

2. The multilayer coated member (10, 20) according to claim 1,
wherein the amorphous inorganic material layer (12) has a thickness of 1 to 1000 µm.

3. The multilayer coated member (10, 20) according to any one of claim 1 or 2,
wherein the amorphous inorganic material layer (12) contains particles of a crystalline inorganic material (14).

4. The multilayer coated member (10, 20) according to claim 3,
wherein the crystalline inorganic material is an oxide containing at least one of manganese dioxide, manganese oxide, iron oxide, cobalt oxide, copper oxide, chromium oxide, and nickel oxide.

5. The multilayer coated member (10, 20) according to claim 3,
wherein the crystalline inorganic material is an oxide containing at least one of zirconia, yttria, calcia, magnesia, ceria, alumina, titania, niobium oxide, and hafnia.

6. The multilayer coated member (10, 20) according to any one of claims 1 to 5,
wherein the substrate (11) contains stainless steel, heat-resistant steel, aluminum, or aluminum alloy.

7. The multilayer coated member (10, 20) according to any one of claims 1 to 6,
wherein the non-oxide ceramic layer (13) has a thickness of 1 to 1000 µm.

8. The multilayer coated member (10, 20) according to any one of claims 1 to 7,
wherein the non-oxide ceramic layer (13) contains silicon carbide.

9. A method of producing a multilayer coated member (10, 20), the method comprising:
a substrate providing step of providing a substrate containing a metal (11);
a material composition preparing step of preparing a material composition for an amorphous inorganic material layer (12) containing an amorphous inorganic material;
a material composition applying step of applying the material composition for an amorphous inorganic material layer (12) containing an amorphous inorganic material to the substrate (11) and drying the material composition to form a layer of the material composition for an amorphous inorganic material layer (12) on the substrate (11);
a firing step of heating the substrate (11) on which the layer of the material composition for an amorphous inorganic material layer is formed at 400°C to 1100°C for 3 to 120 minutes to form an amorphous inorganic material layer (12); and
a non-oxide ceramic layer forming step of forming a non-oxide ceramic layer (13) on the amorphous inorganic material layer (12) by a laser CVD method.

10. The method of producing a multilayer coated member (10, 20) according to claim 9,
wherein, in the substrate providing step, the substrate (11) is roughened.

11. The method of producing a multilayer coated member (10, 20) according to claim 9 or 10,
wherein, in the non-oxide ceramic layer forming step, the amorphous inorganic material layer (12) in formation of the non-oxide ceramic layer (13) has a temperature of 300°C to 1000°C.

12. The method of producing a multilayer coated member (10, 20) according to any one of claims 9 to 11,
wherein the amorphous inorganic material layer (12) is formed using an amorphous inorganic material containing a low-melting glass having a softening point of 300°C to 1000°C.

13. The method of producing a multilayer coated member (10, 20) according to any one of claims 9 to 12,
wherein the amorphous inorganic material layer (12) formed has a thickness of 1 to 1000 µm.

14. The method of producing a multilayer coated member (10, 20) according to any one of claims 9 to 13,
wherein, in the material composition preparing step, the material composition for an amorphous inorganic material layer (12) contains particles of a crystalline inorganic material (14).

15. The method of producing a multilayer coated member (10, 20) according to claim 14,
wherein the crystalline inorganic material is an oxide containing at least one of manganese dioxide, manganese oxide, iron oxide, cobalt oxide, copper oxide, chromium oxide, and nickel oxide.

16. The method of producing a multilayer coated member (10, 20) according to claim 14,
wherein the crystalline inorganic material is an oxide containing at least one of zirconia, yttria, calcia, magnesia, ceria, alumina, titania, niobium oxide, and hafnia.

17. The method of producing a multilayer coated member (10, 20) according to any one of claims 1 to 6,
wherein the substrate (11) contains stainless steel, heat-resistant steel, aluminum, or aluminum alloy.

18. The method of producing a multilayer coated member (10, 20) according to any one of claims 9 to 17,
wherein the non-oxide ceramic layer (13) formed has a thickness of 1 to 1000 µm.

19. The method of producing a multilayer coated member (10, 20) according to any one of claims 9 to 18,
wherein the non-oxide ceramic layer (13) contains silicon carbide.

## Patentansprüche

1. Mehrschichtig beschichtetes Element (10, 20), umfassend:
ein Substrat (11), das ein Metall enthält;
eine amorphe anorganische Materialschicht (12), die auf dem Substrat (11) gebildet ist; und
eine Nichtoxidkeramikschicht (13), die auf der amorphen anorganischen Materialschicht (12) gebildet ist,
**dadurch gekennzeichnet, dass**
die amorphe anorganische Materialschicht (12) ein amorphes anorganisches Material enthält, das ein niedrigschmelzendes Glas mit einem Erweichungspunkt von 300 °C bis 1000 °C enthält.

2. Mehrschichtig beschichtetes Element (10, 20) nach Anspruch 1,
wobei die amorphe anorganische Materialschicht (12) eine Dicke von 1 bis 1000 µm aufweist.

3. Mehrschichtig beschichtetes Element (10, 20) nach einem der Ansprüche 1 oder 2,
wobei die amorphe anorganische Materialschicht (12) Partikel eines kristallinen anorganischen Materials (14) enthält.

4. Mehrschichtig beschichtetes Element (10, 20) nach Anspruch 3,
wobei das kristalline anorganische Material ein Oxid ist, das wenigstens eines von Mangandioxid, Manganoxid, Eisenoxid, Kobaltoxid, Kupferoxid, Chromoxid und Nickeloxid enthält.

5. Mehrschichtig beschichtetes Element (10, 20) nach Anspruch 3,
wobei das kristalline anorganische Material ein Oxid ist, das wenigstens eines von Zirconiumdioxid, Yttriumoxid, Calciumoxid, Magnesiumoxid, Cerdioxid, Aluminiumoxid, Titandioxid, Nioboxid und Hafniumoxid enthält.

6. Mehrschichtig beschichtetes Element (10, 20) nach einem der Ansprüche 1 bis 5,
wobei das Substrat (11) rostfreien Stahl, hitzebeständigen Stahl, Aluminium oder Aluminiumlegierung enthält.

7. Mehrschichtig beschichtetes Element (10, 20) nach einem der Ansprüche 1 bis 6,
wobei die Nichtoxidkeramikschicht (13) eine Dicke von 1 bis 1000 µm aufweist.

8. Mehrschichtig beschichtetes Element (10, 20) nach einem der Ansprüche 1 bis 7, wobei die Nichtoxidkeramikschicht (13) Siliciumcarbid enthält.

9. Verfahren zur Herstellung eines mehrschichtig beschichteten Elements (10, 20), wobei das Verfahren umfasst:
einen Schritt des Bereitstellens eines Substrats, bei dem ein Substrat (11) bereitgestellt wird, das ein Metall enthält;
einen Schritt der Herstellung einer Materialzusammensetzung, bei dem eine Materialzusammensetzung für eine amorphe anorganische Materialschicht (12) hergestellt wird, die ein amorphes anorganisches Material enthält;
einen Schritt des Aufbringens der Materialzusammensetzung, bei dem die Materialzusammensetzung für eine amorphe anorganische Materialschicht (12), die ein amorphes anorganisches Material enthält, auf das Substrat (11) aufgebracht und die Materialzusammensetzung unter Bildung einer Schicht der Materialzusammensetzung für eine amorphe anorganische Materialschicht (12) auf dem Substrat (11) getrocknet wird;
einen Brennschritt, bei dem das Substrat (11), auf dem die Schicht der Materialzusammensetzung für eine amorphe anorganische Materialschicht gebildet ist, bei 400°C bis 1100°C für 3 bis 120 Minuten unter Bildung einer amorphen anorganische Materialschicht (12) gebrannt wird; und
einen Schritt der Bildung einer Nichtoxidkeramikschicht, bei dem eine Nichtoxidkeramikschicht (13) auf der amorphen anorganischen Materialschicht (12) durch ein Laser-CVD-Verfahren gebildet wird.

10. Verfahren zur Herstellung eines mehrschichtig beschichteten Elements (10, 20) nach Anspruch 9,
wobei das Substrat (11) bei dem Schritt des Bereitstellens des Substrats aufgeraut wird.

11. Verfahren zur Herstellung eines mehrschichtig beschichteten Elements (10, 20) nach Anspruch 9 oder 10,
wobei, bei dem Schritt der Bildung der Nichtoxidkeramikschicht, die amorphe anorganische Materialschicht (12) bei Bildung der Nichtoxidkeramikschicht (13) eine Temperatur von 300 °C bis 1000 °C hat.

12. Verfahren zur Herstellung eines mehrschichtig beschichteten Elements (10, 20) nach einem der Ansprüche 9 bis 11,
wobei die amorphe anorganische Materialschicht (12) unter Verwendung eines amorphen anorganischen Materials gebildet wird, das ein niedrigschmelzendes Glas mit einem Erweichungspunkt von 300 °C bis 1000 °C enthält.

13. Verfahren zur Herstellung eines mehrschichtig beschichteten Elements (10, 20) nach einem der Ansprüche 9 bis 12,
wobei die gebildete amorphe anorganische Materialschicht (12) eine Dicke von 1 bis 1000 µm aufweist.

14. Verfahren zur Herstellung eines mehrschichtig beschichteten Elements (10, 20) nach einem der Ansprüche 9 bis 13,
wobei die Materialzusammensetzung für eine amorphe anorganische Materialschicht (12) bei dem Schritt der Herstellung der Materialzusammensetzung Partikel eines kristallinen anorganischen Materials (14) enthält.

15. Verfahren zur Herstellung eines mehrschichtig beschichteten Elements (10, 20) nach Anspruch 14,
wobei das kristalline anorganische Material ein Oxid ist, das wenigstens eines von Mangandioxid, Manganoxid, Eisenoxid, Kobaltoxid, Kupferoxid, Chromoxid und Nickeloxid enthält.

16. Verfahren zur Herstellung eines mehrschichtig beschichteten Elements (10, 20) nach Anspruch 14,
wobei das kristalline anorganische Material ein Oxid ist, das wenigstens eines von Zirconiumdioxid, Yttriumoxid, Calciumoxid, Magnesiumoxid, Cerdioxid, Aluminiumoxid, Titandioxid, Nioboxid und Hafniumoxid enthält.

17. Verfahren zur Herstellung eines mehrschichtig beschichteten Elements (10, 20) nach einem der Ansprüche 1 bis 6,
wobei das Substrat (11) rostfreien Stahl, hitzebeständigen Stahl, Aluminium oder Aluminiumlegierung enthält.

18. Verfahren zur Herstellung eines mehrschichtig beschichteten Elements (10, 20) nach einem der Ansprüche 9 bis 17,
wobei die gebildete Nichtoxidkeramikschicht (13) eine Dicke von 1 bis 1000 µm aufweist.

19. Verfahren zur Herstellung eines mehrschichtig beschichteten Elements (10, 20) nach einem der Ansprüche 9 bis 18,
wobei die Nichtoxidkeramikschicht (13) Siliciumcarbid enthält.

## Revendications

1. Elément revêtu multicouche (10, 20), comprenant :
un substrat (11) contenant un métal ;
une couche de matière inorganique amorphe (12) formée sur le substrat (11) ; et
une couche céramique de non-oxyde (13) formée sur la couche de matière inorganique amorphe (12),
**caractérisé en ce que**
la couche de matière inorganique amorphe (12) contient une matière inorganique amorphe qui contient un verre de faible point de fusion ayant un point de ramollissement de 300°C à 1 000°C.

2. Elément revêtu multicouche (10, 20) selon la revendication 1,
dans lequel la couche de matière inorganique amorphe (12) présente une épaisseur de 1 à 1 000 µm.

3. Elément revêtu multicouche (10, 20) selon l'une quelconque de la revendication 1 ou 2,
dans lequel la couche de matière inorganique amorphe (12) contient des particules d'une matière inorganique cristalline (14).

4. Elément revêtu multicouche (10, 20) selon la revendication 3,
dans lequel la matière inorganique cristalline est un oxyde contenant au moins un de dioxyde de manganèse, oxyde de manganèse, oxyde de fer, oxyde de cobalt, oxyde de cuivre, oxyde de chrome, et oxyde de nickel.

5. Elément revêtu multicouche (10, 20) selon la revendication 3,
dans lequel la matière inorganique cristalline est un oxyde contenant au moins un d'oxyde de zirconium, oxyde d'yttrium, oxyde de calcium, magnésie, oxyde de cérium, alumine, oxyde de titane, oxyde de niobium, et oxyde d'hafnium.

6. Elément revêtu multicouche (10, 20) selon l'une quelconque des revendications 1 à 5,
dans lequel le substrat (11) contient de l'acier inoxydable, de l'acier résistant à la chaleur, de l'aluminium, ou un alliage d'aluminium.

7. Elément revêtu multicouche (10, 20) selon l'une quelconque des revendications 1 à 6,
dans lequel la couche céramique de non-oxyde (13) présente une épaisseur de 1 à 1 000 µm.

8. Elément revêtu multicouche (10, 20) selon l'une quelconque des revendications 1 à 7,
dans lequel la couche céramique de non-oxyde (13) contient du carbure de silicium.

9. Procédé de production d'un élément revêtu multicouche (10, 20), le procédé comprenant :
une étape de fourniture de substrat fournissant un substrat contenant un métal (11) ;
une étape de préparation de composition de matière préparant une composition de matière pour une couche de matière inorganique amorphe (12) contenant une matière inorganique amorphe ;
une étape d'application de composition de matière appliquant la composition de matière pour une couche de matière inorganique amorphe (12) contenant une matière inorganique amorphe au substrat (11) et séchant la composition de matière pour former une couche de la composition de matière pour une couche de matière inorganique amorphe (12) sur le substrat (11) ;
une étape de cuisson chauffant le substrat (11) sur lequel la couche de la composition de matière pour une couche de matière inorganique amorphe est formée à de 400°C à 1 100°C pendant de 3 à 120 minutes pour former une couche de matière inorganique amorphe (12) ; et
une étape de formation de couche céramique de non-oxyde formant une couche céramique de non-oxyde (13) sur la couche de matière inorganique amorphe (12) par un procédé CVD au laser.

10. Procédé de production d'un élément revêtu multicouche (10, 20) selon la revendication 9,
dans lequel dans l'étape de fourniture de substrat, le substrat (11) est rendu rugueux.

11. Procédé de production d'un élément revêtu multicouche (10, 20) selon la revendication 9 ou 10,
dans lequel, dans l'étape de formation de couche céramique de non-oxyde, la couche de matière inorganique amorphe (12) dans la formation de la couche céramique de non-oxyde (13) présente une température de 300°C à 1 000°C.

12. Procédé de production d'un élément revêtu multicouche (10, 20) selon l'une quelconque des revendications 9 à 11,
dans lequel la couche de matière inorganique amorphe (12) est formée en utilisant une matière inorganique amorphe contenant un verre de faible point de fusion ayant un point de ramollissement de 300°C à 1 000°C.

13. Procédé de production d'un élément revêtu multicouche (10, 20) selon l'une quelconque des revendications 9 à 12,
dans lequel la couche de matière inorganique amorphe (12) formée présente une épaisseur de 1 à 1 000 µm.

14. Procédé de production d'un élément revêtu multicouche (10, 20) selon l'une quelconque des revendications 9 à 13,
dans lequel, dans l'étape de préparation d'une composition de matière, la composition de matière pour une couche de matière inorganique amorphe (12) contient des particules d'une matière inorganique cristalline (14).

15. Procédé de production d'un élément revêtu multicouche (10, 20) selon la revendication 14,
dans lequel la matière inorganique cristalline est un oxyde contenant au moins un de dioxyde de manganèse, oxyde de manganèse, oxyde de fer, oxyde de cobalt, oxyde de cuivre, oxyde de chrome, et oxyde de nickel.

16. Procédé de production d'un élément revêtu multicouche (10, 20) selon la revendication 14,
dans lequel la matière inorganique cristalline est un oxyde contenant au moins un d'oxyde de zirconium, oxyde d'yttrium, oxyde de calcium, magnésie, oxyde de cérium, alumine, oxyde de titane, oxyde de niobium, et oxyde d'hafnium.

17. Procédé de production d'un élément revêtu multicouche (10, 20) selon l'une quelconque des revendications 1 à 6,
dans lequel le substrat (11) contient de l'acier inoxydable, de l'acier résistant à la chaleur, de l'aluminium, ou un alliage d'aluminium.

18. Procédé de production d'un élément revêtu multicouche (10, 20) selon l'une quelconque des revendications 9 à 17,
dans lequel la couche céramique de non-oxyde (13) formée présente une épaisseur de 1 à 1 000 µm.

19. Procédé de production d'un élément revêtu multicouche (10, 20) selon l'une quelconque des revendications 9 à 18,
dans lequel la couche céramique de non-oxyde (13) contient du carbure de silicium.
